# EUROPEAN PATENT SPECIFICATION

(11) **EP 4 374 719 B1**
(45) Date of publication and mention of the grant of the patent: **30.04.2025**
(21) Application number: 22209667.9
(22) Date of filing: 25.11.2022
(51) Int. Cl.: A24F 40/40

(54) **AN AEROSOL GENERATION DEVICE, AND A METHOD OF OPENING AN AEROSOL GENERATION CHAMBER THEREOF**
AEROSOLERZEUGUNGSVORRICHTUNG UND VERFAHREN ZUM ÖFFNEN EINER AEROSOLERZEUGUNGSKAMMER DAVON
DISPOSITIF DE GÉNÉRATION D'AÉROSOL ET PROCÉDÉ D'OUVERTURE D'UNE CHAMBRE DE GÉNÉRATION D'AÉROSOL ASSOCIÉ

(43) Date of publication of application: 29.05.2024
(73) Proprietor: JT International SA, 1202 Geneva (CH)
(72) Inventor: LENEMAN, Marijn, 8014 DE Zwolle (NL); HUPKES, Ernst, 8261HL Kampen (NL)
(74) Representative: Bardehle Pagenberg Partnerschaft mbB Patentanwälte Rechtsanwälte

(56) References cited:
- US-A1- 2021 015 151
- US-A1- 2022 142 247
- US-A1- 2022 183 357
- US-A1- 2022 287 362

## Description

### Technical Field

The present disclosure relates to an aerosol generation device, particularly to a portable aerosol generation device, a method of opening its aerosol generation chamber, and a manually operated slider construction. Such devices may heat, rather than burn, tobacco or other suitable aerosol substrate materials by conduction, convection, and/or radiation, to generate an aerosol for inhalation. US-A-2022/287362 discloses an aerosol generation device comprising a housing and an aerosol generation chamber provided with a movable cover for covering an opening of the device. The cover is by means of a biasing element held in an open or closed position.

### Technical Background

The popularity and use of reduced-risk or modified-risk devices (also known as vaporizers) have grown rapidly in recent years as an alternative to the use of traditional tobacco products. Various devices and systems are available that heat or warm, rather than burn, an aerosol generating substrate to generate an aerosol for inhalation by a user.

A commonly available reduced-risk or modified-risk device is the heated substrate aerosol generation device or heat-not-burn device. Devices of this type generate an aerosol or vapor by heating an aerosol substrate that typically comprises moist leaf tobacco or other suitable aerosol generating material to a temperature typically in the range 150 °C to 300 °C. Heating an aerosol substrate, but not combusting or burning it, releases an aerosol that comprises the components sought by the user. Furthermore, the aerosol produced by heating the tobacco or other aerosol generating material does not typically comprise the burnt or bitter taste resulting from combustion and burning that can be unpleasant for the user, and so the substrate does not require the sugars and other additives that are typically added to such materials to make the smoke and/or vapor more palatable for the user.

It is a long-standing demand to make sure that the way of inserting or removing the aerosol generation article is easy and intuitive for the user. The common arrangements for the housing and the buttons for opening the device make the devices vulnerable to, for example, wet air, dust, liquids in daily life, and bits from the consumable. A common arrangement is to provide a cap or a cover for the chamber containing the consumable article(s), but the conventional structures make it hard to open, easy to break over time, and hardly dust proof, as dust and the like may get caught in the gaps between the cap arrangement and the body of the device.

There is thus a need to provide a solution which mitigates these problems and has the desired advantages. In particular, it is desirable to provide a portable and compact device with improved safety and/or reliability.

### Summary of the Invention

The present invention provides an aerosol generation device which solves some or all of the above problems.

According to a first aspect of the present disclosure, there is provided an aerosol generation device, comprising:
- a housing,
- an aerosol generation chamber configured to receive a substrate to generate aerosol and having an opening which is at least partially not covered by the housing,
- a cover configured to be in a closed position covering the opening, or in an open position exposing the opening,
- an opening mechanism connected with the cover and comprising a biasing element biasing the cover toward the open position, and a locking element configured to releasably lock the cover in the closed position;

the opening mechanism being configured to be in a covering state, an open state, or a partially open state; wherein
when the opening mechanism is in the covering state, the locking element holds the cover in the closed position, and the opening mechanism can be translated into the partially open state,
when the opening mechanism is in the open state, the biasing element holds the cover in the open position, and the opening mechanism can be translated into the partially open state, and
when the opening mechanism is in the partially open state, the cover is configured to move from the closed position to the open position by a force of the biasing element, or from the open position to the closed position by a force of the user pushing the cover until the cover is locked by the locking element.

The arrangement in which the opening mechanism is biased to stay open, but can be locked in the closed position increases the robustness of the cover of the aerosol generation device, and makes the operation of the cover easy and intuitive.

In a second aspect of the present disclosure, according to the preceding aspect, the locking element is further configured unlock to the cover by an operation of the user when the cover is in the closed position.

This arrangement prevents unintentional opening of the cover.

In a third aspect of the present disclosure, according to any one of the above aspects,
when the opening mechanism transitions from the covering state to the open state, the cover first moves in a first direction by a force of the user so that the cover is unlocked from the closed position, and then moves in a second direction, which is different from the first direction, to the open position; and
when the opening mechanism transitions from the open state to the covering state, the cover moves from the open position to the closed position by a force of the user pushing the cover in a third direction, which is opposite to the second direction, until the cover is locked by the locking element in the closed position.

In a fourth aspect of the present disclosure, according to any one of the above aspects, the cover comprises a covering surface configured to cover the aerosol generation chamber when the cover is in the closed position, and a sealing surface configured to cover the opening mechanism when the cover is in the open position; wherein the covering surface is preferably provided on a protrusion of the cover.

With this arrangement of the covering surface, the inner space of the device, and especially the opening mechanism, is protected from the ingress of vape/dirt.

In a fifth aspect of the present disclosure, according to the preceding aspect, when the cover is in the open position, the sealing surface forms a seamless surface with a surrounding surface of the aerosol generation chamber around the sealing surface so as to cover the opening mechanism.

This arrangement improves the dust-proof performance of the cover, especially prevents dust or the like from getting tangled up in the cover.

In a sixth aspect of the present disclosure, according to any one of the above aspects, the opening mechanism comprises a guide track and a first slider engaged with the cover and configured to slidingly engage with the guide track so that the cover can slide between the open position and the closed position.

In a seventh aspect of the present disclosure, according to the preceding aspect, the locking element is a groove arranged on the guide track.

In an eighth aspect of the present disclosure, according to the sixth or seventh aspect, the guide track has a first end and a second end, and when the cover is in the open position, the first slider is held at the first end by the biasing element.

In a ninth aspect of the present disclosure, according to the preceding aspect, the locking element is arranged on the guide track and in a position between the first end and the second end, so that, when the first slider engages with the locking element, the cover is held in the closed position against the force of the biasing element, and when the cover is moved in the first direction, the first slider is moved in a way such that the first slider can be released from the locking element so as to unlock the cover from the closed position.

In a tenth aspect of the present disclosure, according to the preceding aspect, the opening mechanism comprises a second slider engaged with the cover and configured to slidingly engage with the guide track, and when the first slider moves from or engages with the locking element, the second slider is configured to be the rotation point for the first slider.

In an eleventh aspect of the present disclosure, according to anyone of the preceding aspects, the second slider is arranged at the end of the cover that is closest to the center of the opening of the aerosol generation chamber when the cover is in the open position.

In a twelfth aspect of the present disclosure, according to any one of the preceding aspects, the opening mechanism comprises a rigid element, the first slider is provided on the rigid element at a first end of the rigid element and the second slider is provided on a second end of the rigid element, and the rigid element is connected with the cover.

In a thirteenth aspect of the present disclosure, according to the preceding aspect, the first slider is distanced from the second slider such that when the second slider moves along the guide track, the second slider does not fall into the groove.

In a fourteenth aspect of the present disclosure, according to any one of the preceding aspects, the cover comprises a protrusion comprising the second slider, and the sealing surface is provided on the protrusion.

In a fifteenth aspect of the present disclosure, according to the sixth to twelfth aspects, the housing comprises a sliding surface, the cover is configured to slide along the sliding surface, and the guide track is arranged in such a way that a part of the trace of the first slider is substantially parallel to an outline of the sliding surface.

In a fifteenth aspect of the present disclosure, according to any one of the above aspects, the cover forms a seamless surface with a surrounding surface of the housing around the cover when the cover is in the closed position.

This arrangement brings the benefit of preventing the ingress of material or dust.

In a sixteenth aspect of the present disclosure, according to any one of the above aspects, the locking element comprises a sensor arranged to halt at least one function of the device once the sensor detects the engagement of the opening mechanism and the locking element.

This arrangement improves the safety of using the device.

In a seventeenth aspect of the present disclosure, according to any one of the above aspects, the device further comprises an LED light arranged to indicate the locking state of cover.

This arrangement makes the user easily understand whether the cover is locked in place.

An eighteenth aspect of the present disclosure is a method of opening an aerosol generation device according to any one of the preceding aspects, comprising the step of pushing the cover of the aerosol generation device down so as to unlock the locking element that locks the cover in the closed position.

Preferred embodiments are now described, by way of example only, with reference to the accompanying drawings.

### BRIEF DESCRIPTION OF THE DRAWINGS

Figure 1: is a schematic diagram of an aerosol generating device of an embodiment of this invention;
Figure 2: is an exploded view of a closure of the aerosol generation device of an embodiment of this invention;
Figure 3(a): is a schematic diagram of a closure of an embodiment of this invention;
Figure 3(b): is a schematic diagram of a portion of an opening mechanism and a cover of an embodiment of this invention.
Figure 4(a): is a schematic cross-sectional view of an opening mechanism of an embodiment of this invention, where the opening mechanism is in a covering state, and the cover is at a closed position;
Figure 4(b): is a schematic cross-sectional view of the opening mechanism of the embodiment of Figure 4(a), where the opening mechanism is in a partially open state, especially when the locking element is unlocked;
Figure 4(c): is a schematic cross-sectional view of the track of the opening mechanism of the embodiment of Figures 4(a) and 4(b), where the opening mechanism is in an open state, and the cover is at an open position;
Figure 5(a): is a schematic cross-sectional view of a guide track of an embodiment of this invention, where the opening mechanism is in a covering state;
Figure 5(b): is a schematic cross-sectional view of the track of the embodiment of Figure 5(a), where the opening mechanism is transitioning from the covering state to a partially open state; and,
Figure 5(c): is a schematic cross-sectional view of the track of the embodiment of Figure 5(a) and 5(b), where the closure is in the partially open state.

### DETAILED DESCRIPTION OF THE PREFERRED EMBODIMENTS

Preferred embodiments of the present invention are described hereinafter and in conjunction with the accompanying drawings.

In the description of the present invention, it should be understood that the orientation or positional relationship terms "one end", "another end", "the other end", "outside", "inside", "upper", "lower", "above", "top", "bottom", "horizontal", "coaxial", "central", "length", "distance", etc. is based on the orientation or positional relationship shown in the accompanying drawings, and is only for the convenience of describing the present invention and simplifying the description. Specifically, the orientation or positional relationship terms should be understood as the aerosol-generating device 1 being in its upright position (top-down) and/or taking the center of the opening of the aerosol generation chamber 12 as the center point or reference. Otherwise, the specific meanings of the above terms in the present invention should be understood according to specific situations that make the most technical sense for the skilled person in the art.

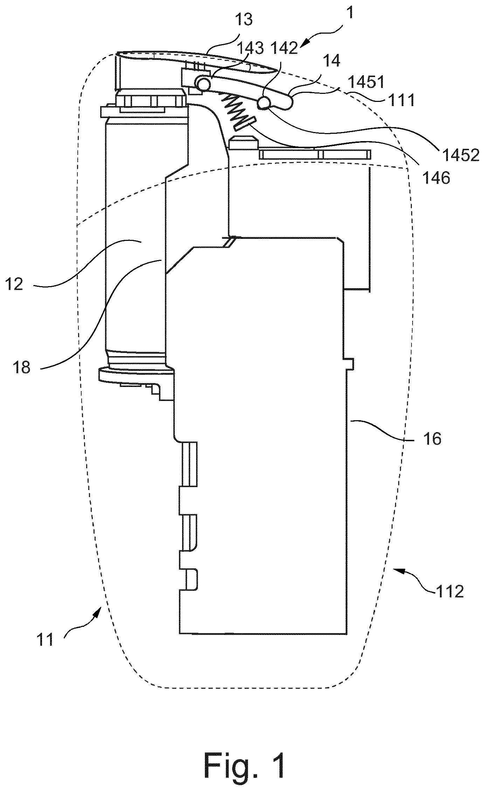

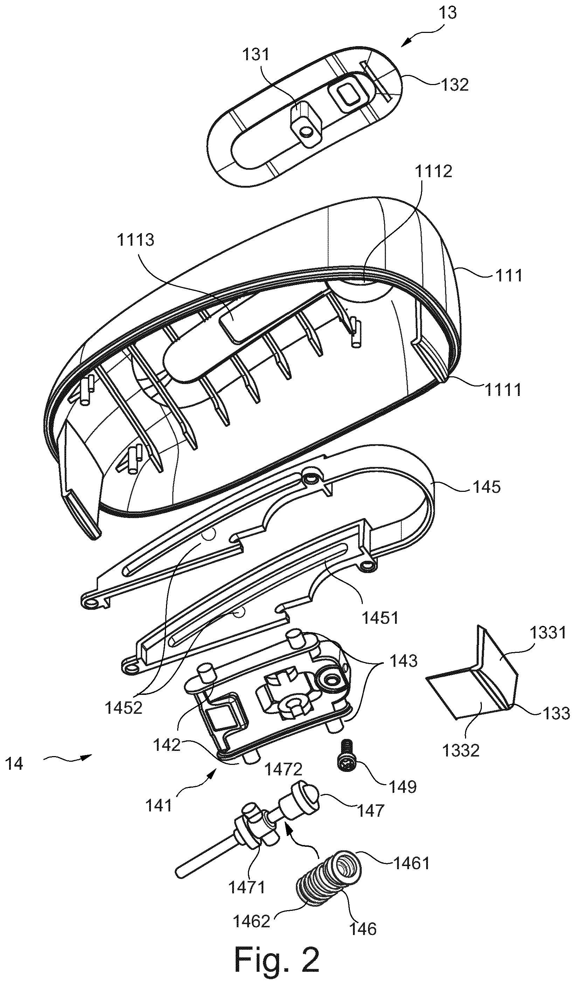

As an overview of an aerosol-generating device 1 of an embodiment of the present invention, Figure 1 illustrates an aerosol-generating device 1 with some of its subassemblies. Figures 2 to 6 show more details of some of the subassemblies. For ease of understanding and brevity, certain features shown in the drawings have not been described in detail and certain features have been omitted entirely. As used herein, the term "aerosol generation device", "E-cigarette" or "electronic cigarette" may include an electronic cigarette system configured to deliver an aerosol to a user, including an aerosol for smoking.

### - Aerosol Generating Device

Referring to **Figure 1****,** according to an embodiment of the present invention, the portable aerosol generating device 1 has a generally elongated shape with a closure part 111 (i.e., the upper part in the figure), from where a consumable can be inserted, and a main part 112 (i.e., the lower part in the figure) opposite to the closure part 111 for holding the device in the hand. The aerosol generating device 1 may also be of any other shape as long as it is sized to fit the subassemblies and a consumable. The housing 11 can be formed of any suitable material, or layers of material. The aerosol generating device 1 includes a housing subassembly 11, which is shown as "transparent" (shown with dashed edges), housing various subassemblies of the aerosol generation device 1. In addition, within the housing 11, the aerosol generating device 1 includes an aerosol generation chamber subassembly 12, a cover subassembly 13, an opening mechanism 14, an electrical power supply subassembly (preferably a LiPo battery) 16, and a device internal chassis 18 subassembly that fixes most of the other subassemblies together. The illustrated embodiments of the aerosol generation device 1 in this invention are schematic, and it is possible to combine other elements which are omitted in here for conciseness, such as the aerosol inlet and outlet, input device (e.g., a controlling button), PCBs, operator or computer modules, which is apparent to a skilled person in the art.

The closure 111 is located at the top, with the cover 13 for opening and closing the inlet or opening to the aerosol generation chamber 12 for the user for supplying the consumable to be heated in the heating chamber. Snap-fit connectors, or other types of attaching means, may be provided in the closure 111 to attach to the main part 112.

The aerosol generation chamber 12 comprises a cylinder unit defining an inner space for containing the consumable (not shown), a heater (not shown) arranged near or around the cylinder unit to supply heat to the aerosol generation chamber 12, and an opening (aperture) which is arranged at the "upper" side of the cylinder unit and is at least partially not covered by the housing. In other words, the opening exposes the inner space of the aerosol generation chamber 12 for (completely or partially) receiving the consumable in an insertion direction of the consumable. Although it is named a "cylinder unit", it will be appreciated that any shape may be used, such as a square and triangular shape.

Although not shown in the figures, the consumable which can be inserted into the aerosol generation chamber 12 may be any consumable available in the market, such as an aerosol substrate having nicotine, or a cartridge having a mouthpiece and a container containing the consumable liquid having an aerosol-forming substance.

The cover 13 is arranged to cover the aerosol generation chamber 12, more specifically, the opening of the aerosol generation chamber 12, after use or for enclosing the consumable. In order to have a better dust proof performance, the cover 13 is preferably configured to form a seamless surface with a surrounding surface of the housing 11 (i.e., the closure 111) around the cover when the cover 13 completely covers the opening of the aerosol generation chamber 12. For the ease of opening the cover 13, the opening mechanism 14 is attached to the cover 13. The opening mechanism 14 comprises a slider cart 141 (partially hidden in Figure 1 for the ease of understanding and visibility of the other components) having a first slider 142 and a second slider 143, and a guide track 1451 functioning as a slider rail for the sliders 141 and 142 to slide there along so that the cover 13 can slide between an open position and a closed position. In other words, at least one of the sliders 142 and 143 is configured to slidingly engage with the guide track 1451 so that the cover 13 can slide between the open position and the closed position. In the closed position, the opening of the aerosol generation chamber 12 is blocked by the cover 13 so that material, such as a consumable or moisture and, especially, dust, cannot enter into the aerosol generation chamber 12. In the open position, the opening and the inner space in the aerosol generation chamber 12 are open and exposed, and the opening in the aerosol generation chamber 12 provides access to its inner space from outside. In a preferred embodiment, spacing elements or insulation elements may be provided in the aerosol generation chamber 12 at the opening for increasing the thermal insulation of the aerosol generation chamber 12.

The opening mechanism 14 also comprises a biasing element 146 and locking element 1452. The biasing element 146 is configured to constantly push the slider cart and cover 13 to the open position. This helps to ensure that the aerosol generation chamber 12 remains opening during use. The locking element 1452 is configured to releasably lock the cover 13 in the closed position. This helps to ensure that the aerosol generation chamber 12 is covered when the device 1 is not in use. Hereinafter, the closure 111, more specifically the cover 13 and the opening mechanism 14, are explained in detail.

### - Closure (Cover, Covering Piece, Opening Mechanism and Locking element)

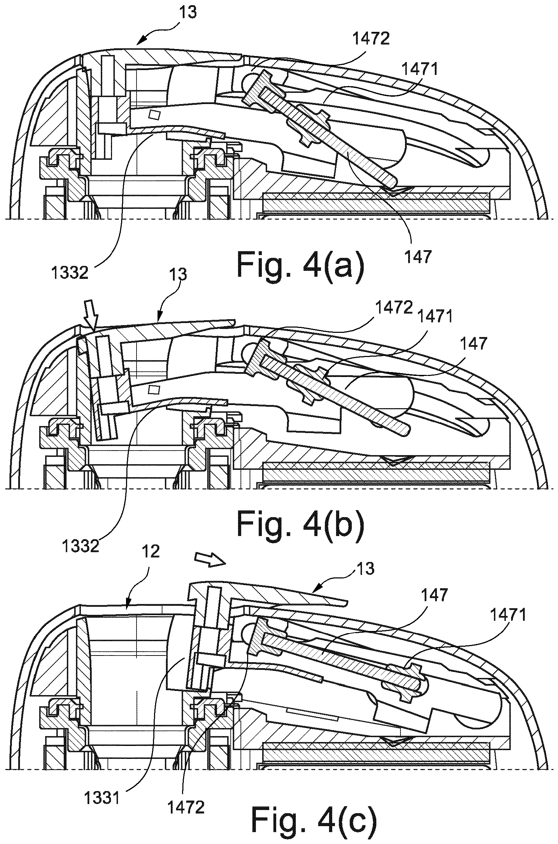

**Figure 2** is an exploded component view of the closure 111 according to an embodiment of the present invention. For the ease of understanding and visibility of the other components, the biasing element 146 is hidden in Figures 4(a) to 5(c).

The closure part 111 has a mounting mechanism 1111, a closure opening 1112 and a channel 1113. The mounting mechanism 1111 is arranged to mount the closure part 111 to the main part 112 of the aerosol generation device 1 so as to form the complete housing 11. The closure opening 1112 is arranged to enable access to the opening of the aerosol generation chamber 12. In some of the preferred embodiments, the closure opening 1112 is the opening of the aerosol generation chamber 12. At least a part of the cover 13 (i.e., a linking part 131 or the covering piece 133 of the cover 13) is arranged to stick into the channel, such that, by interacting with the cover 13, a user can move the cover 13 along the channel 1113. Preferably, the cover 13 is capable of forming a seamless surface with a surrounding surface of the housing 11 (i.e., the closure 111) around the cover 13 when the cover 13 is in the closed position. In other words, the external part 132 of the cover 13 is sized and shaped in a way such that in the open position the opening of the aerosol generation chamber 12 is substantially uncovered, preferably completely uncovered, thereby allowing the ingress of material into the aerosol generation chamber 12; and in the closed position the opening of the aerosol generation chamber 12 is completely covered and the access thereto is blocked, thereby preventing the ingress of material into the aerosol generation chamber 12.

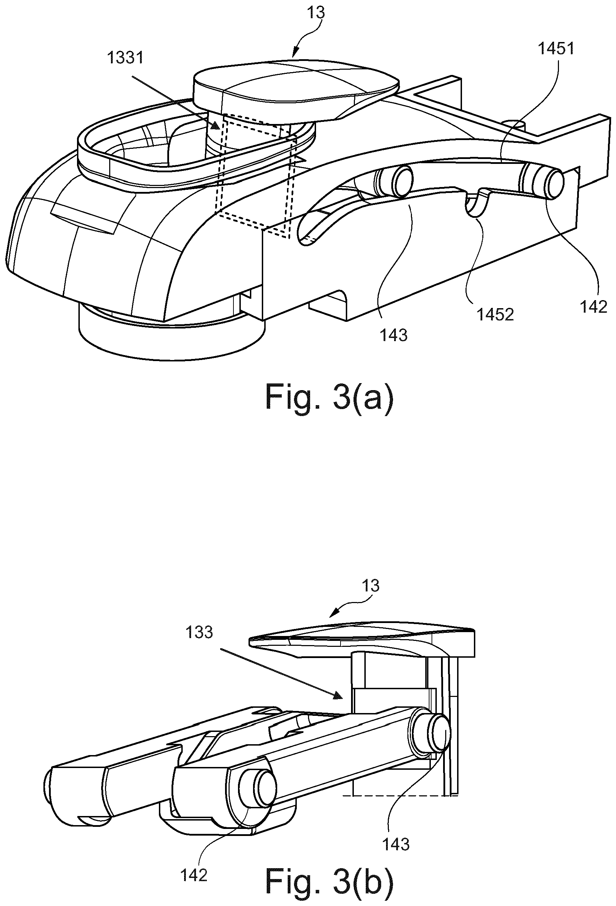

In order to protect the opening mechanism 14, as shown in **Figures 2****,** **3(a) and 3(b)****,** a covering piece 133 is preferably provided as a separator for the opening mechanism 14 and the aerosol generation chamber 12, which prevents the ingress of the material or dust into the inner space of the device 1, and especially the opening mechanism. The covering piece 133 is a separate piece that can be fixed to the cover 13 as shown in Figure 2, or a protrusion that is integrated with the cover 13 as shown in Figure 3(a). The covering piece 133 is preferably arranged at an end of the cover 13 that is near the opening when the cover 13 is in the closed position. Preferably, the covering piece 133 has a substantially L-shaped side-view. A horizontal covering surface 1332 of the covering piece 133 is configured to cover the aerosol generation chamber 12 when the cover 13 is in the closed position and is preferably a curved surface that is adapted with the curve shape of the trajectory of the guide track 1451 as shown in Figures 4(a) to 4(c). A vertical sealing surface 1331 is configured to cover the opening mechanism 14 when the cover 13 is in the open position and is preferably a flat surface as shown in Figure 3(a). Preferably, the sealing surface 1331 is sized so as to form a (seamless) surface with a surrounding surface of the inner wall of the aerosol generation chamber 12 around the sealing surface when the cover 13 is in the open position, so as to cover the opening mechanism and the other parts of the device 1. More preferably, both the horizontal and vertical covering surfaces 1331, 1332 are sized such that the opening mechanism 14 is completely separated from the chamber 12. The covering piece 133 thus prevents the ingress of the material or dust and reduces the conduction of heat from the chamber 12 into the inner space of the device 1, and especially the opening mechanism 14. There is preferably an air gap provided within the covering piece 133, so that transfer of heat from the chamber 12 to the opening mechanism 14 is reduced. In order to increase the thermal insulation further, the covering piece 133 is made of insulation material such as fibrous or foam material, e.g., wool. Any other insulation means may also be used therein.

As explained above, the cover 13 is arranged externally to the housing 11 and is thereby available for interaction with a user so as to be moveable by sliding relative to the housing 11, between at least the closed position, in which the cover 13 obstructs the opening so that articles or dust cannot enter the aerosol generation chamber 12, and the open position, in which the opening is uncovered to allow access to the aerosol generation chamber 12 from outside. In other words, the cover 13 is configured to generally transverse a virtual plane, or a virtual curved surface, formed by the closure opening 1112. The cover 13 is engaged with the opening mechanism 14. More specifically, the cover 13 connects with the opening mechanism 14 via its linking part 131 or the covering piece 133. With a movement of the cover 13, the slider cart 141 is moved accordingly. Preferably, the linking part 131 or the covering piece 133 is attached to the slider cart 141 using, for example a screw 149 or other kinds of attachment means. Alternatively, as shown in Figure 3(b), the slider cart 141 is fixed or hinged to the covering piece 133, and specifically, to an end of the slider cart 141 having the second slider 143.

The guide track 1451 is located in a guide track subassembly 145 that is fixed to the closure 1111, e.g. by screws. Preferably, the guide track subassembly 145 comprises two guide tracks 1451, enclosed by material to the top and bottom of the guide sections, which extend along either side (i.e., first and second ends) of the guide track subassembly 145. The guide track subassembly 145 has preferably a U-shape such that between the two guide sections, there is a vacant space where the carriage 124 can be placed within the guide track subassembly 145 and between the two guide sections with the sliders 142 and 143 of the cart 141 located in the guide sections. Preferably, the trajectory or the trace of the guide tracks 1451 is substantially linear and preferably an arc structure so that a force with a substantially constant or linear magnitude is placed on the biasing element 146 as the guide track(s) 1451 move and slide thereon. The trajectory of the guide tracks 1451 has a length defined by the first end, which is away or remote from (the center of) the opening, and a second end, which is closer to (the center of) the opening, between which the sliders 142 and 143 can slide along. Preferably, the housing 11 (the closure 111) has a sliding surface, which is arranged on the closure 111 and has an outline at least a part of which is substantially parallel to a plane defined by the opening. Preferably, as the cover 13 slides along the sliding surface, the guide tracks 1451 are arranged in such a way that a part of the trajectory of the first slider is substantially parallel to or has the same shape as at least a part of the outline of the sliding surface.

The biasing element 146, which is a spring element in this embodiment of the aerosol generation device 1, is configured to bias the cover 13 to move to the opening position. The spring element 146, more specifically a helical compression spring, can be deformed away from a relaxed position (i.e., the open position of the cover 13) to an unstable position (i.e., the closed position of the cover 13). The spring 146 exerts a compressive force or an extensive force along a longitudinal axis defined by (two ends of) a rigid guiding rod 147 of the opening mechanism 14, around which the spring 146 is mounted. The force exerted by the spring 146 is dependent on the deformation, where the magnitude of the force exerted increases as the magnitude of the deformation from the relaxed position increases.

A traveler 1471 is mounted on (around) the rigid guiding rod 147. Specifically, the traveler 1471 is arranged so as to move along the longitudinal axis of the rigid guiding rod 147 in a longitudinal direction. The biasing element 146 is connected (interacts) with the traveler 1471 so that the traveler 1471 can move along the rigid guiding rod 147 with the force exerted from the biasing element 146.

Specifically, the traveler 1471 is arranged in a way such that it can compress the biasing element 146 as it moves along the longitudinal axis of the rigid guiding rod 147. More specifically, one end of the spring 146 (i.e., the rod-connected end 1461) is mounted on the rigid guiding rod 147 (i.e., the hinged end 1472), or other parts of the aerosol generation device 1, and thereby held in place relative to the aerosol generation device 1. Another end of the spring 146 is mounted to the traveler 1471. The traveler 1471 is engaged (either directly or indirectly) with the cart 141. Herein, the traveler 1471 is hinged with the cart 141. The (hinged) end 1472 of the rigid guiding rod 147 is attached (either directly or indirectly, and hinged in the present embodiment) to the housing 11, i.e., the closure 111 or another fixed subassembly of the aerosol generation device 1, thereby held in place relative to the aerosol generation device 1. Therefore, as the guide cart 141 moves along the guide track 1451, the another end of the rigid guiding rod 147 moves, more specifically rotates, together with the biasing element 146 and traveler 1471 within the aerosol generation device 100 about the hinged end 1472 of the rigid guiding rod 147, with the hinged end 1472 being the rotation point.

The traveler 1471 typically comprises a hollow that is arranged to move along the outside of the rigid guiding rod 147. In some embodiments, the rigid guiding rod 147 is a hollow rod, and the traveler 1471 is instead arranged to move inside the rigid element. The traveler 1471 may also be deformable and may be arranged to compress or expand as it interacts with rigid guiding rod 147. Specifically, the traveler 147 is arranged to move longitudinally along the rigid guiding rod 147. The spring 146 is arranged to interact with the traveler 1471 as the traveler 1471 moves along the rigid guiding rod 147 to compress or release the spring 146. When the end of the spring 146 that is engaged with the traveler 147 (i.e., engaging end) is at a position on the guide track 1451 that is an unstable position, there is a net force placed on the engaging end of the spring 146, so that the spring 146 and the cover 13 are biased towards a stable position (i.e., the open position). In some embodiments, the traveler 1471 and/or the rigid guiding rod 147 comprise a limiting mechanism (not shown) that limits the extent to which the traveler 1471 can move longitudinally along the rigid guiding rod 147; this may prevent the traveler 1471 from separating from the rigid guiding rod 147 and/or may limit the extent to which the spring 146 can be deformed.

In addition, the spring 146 is arranged so that at substantially each position of the cover 13 between the closed position and the open position, a component of the deformation of the spring 146, and a component of the force exerted by the spring 146 is in the direction of the movement of the cover 13. The spring 146 is arranged so that when the cover 13 is in the open position, this component of the force resists movement away from the open position. The spring 146 is further arranged so that a component of the deformation of the spring 146, and a component of the force exerted by the spring 146, is transverse to the direction of the movement of the cover 13; this component of the force acts to force the engaging end of the spring 146 against a side of the traveler 1471. This results in a smooth sliding open movement of the cover 13, that is pleasant for the user.

With this arrangement, the biasing element 146 is (gradually) relaxed as the cover 13 moves away from the closed position and to the open position so that the biasing element 146 resists displacement of the cover 13 away from the closed position and to the open position. When the slider(s) 142 is/are at the first end of the guide track(s) 1451, the cover is at the open position, and the spring 146 is at the relaxed position. Although it is named "relaxed position", it will be appreciated that the spring 146 may be still compressed to some extent and thus a smaller force is still exerted from the spring 146. The cover is anyhow not further moveable and remains at its open position as the movement of the slider(s) 142 is stopped by the first end(s) of the guide track 1451, and/or the linked part 131 (or the covering piece 133) of the cover is stopped by an edge of the closure 111 or the housing 11.

In order to hold the cover 13 in the closed position, one or more locking element(s) 1452 is/are provided, to releasably lock the cover in the closed position. Preferably, a locking element 1452 is a groove, a cut-out or a recess on the guide track(s) 1451, arranged between the first end(s) and the second end(s) of the guide track(s) 1451 such that once the first slider(s) 143 of the guide cart 141 arrive(s) at the locking element 1452, the slider(s) 142 fall(s) within and engages with the locking element(s) 1452 so that the guide cart 141 is locked in place and that the spring 146 is compressed. Preferably, the groove 1452 is arranged at a center point of the guide track 1451. Alternatively, the locking element 1452 may have an extension or protrusion of the guide track 1451 with which the sliders 1452 can be locked.

Preferably, the opening mechanism is arranged in such a way that once the cover arrives at the closed position, the first slider(s) 143 can automatically be locked by the locking elements 1452. More specifically, in the preferred embodiment, the rigid guiding rod 147 is arranged in a way such that the end of the rigid guiding rod 147 that is hinged to the housing 11 (i.e., the hinged end 1472) is "above" the portion of the rigid guiding rod 147 that engages with the traveler 1471. In other words, the hinged end 1472 of the rigid guiding rod 147 is closer to the opening than the portion of the rigid guiding rod 147 that engages with the traveler 1471. The range of rotation of the rigid guiding rod 147 is limited in a way such that the traveler 1471 is always at a "lower" position relative to the hinged end 1472, and a remote or further position relative to the opening comparing the hinged end 1472 of the rigid guiding rod 147, when the traveler 1471 moves along the rigid guiding rod 147. The biasing element 146 is arranged on a side of the rigid guiding rod 147 where the rigid guiding rod 147 engages with the traveler 1471 and is preferably arranged between the hinged end 1472 of the rigid guiding rod 147 and the traveler 1471. Alternatively, the biasing element 146 is a pulling spring that is arranged at an end that is opposite to the hinged end 1472 of the rigid guiding rod 147. In such a way, as the (traveler-connected) end 1462 of the biasing element 146 and the traveler 1471 move along the rigid guiding rod 147, the direction of the force exerted by the biasing element 146 always has a component of the force in a "downwards" direction in either the direction of the closed position or in the direction of the open position. For example, the component force is in the direction away from (the center of) the opening of the aerosol generation device 1. Accordingly, the locking element 1452 is arranged at a "lower" side of the guide track(s) 1451 (the longitudinal side of the two longitudinal sides of the guide track 1451 that is at a farther position from the opening). In such a way, once the cover 13 arrives at the closed position, the first slider(s) 142 automatically engages with the locking element(s) 1452 due to the "downwards" component force of the biasing element 146.

In order to unlock the guide cart 141 from the locking element(s) 1452, another (pair of) slider(s) 143 (second slider or second pair of sliders), preferably pins or cylinder-shape protrusions similar to the first slider(s) 142 (first slider or first pair of sliders), are provided next to the other slider(s) 142. Both the first slider(s) 142 and the second slider(s) 143 engage with the guide track(s) 1451. The first slider(s) 142 and the second slider(s) 143 are preferably arranged on two ends of the guide cart 141. The first slider(s) 142 is/are arranged at a position of the cart 141 that is farther away from the opening, and the second slider(s) 143 is/are arranged at a position of the cart 141 that is closer to the opening. In other words, the second slider(s) 143 is/are arranged on or close to the covering piece 133. In such a way, once the cover 13 arrives at the closed position, the first slider(s) 142 automatically engage(s) with the locking element 1452, and the second slider(s) 143 become(s) the pivot point for the guide cart 141. Specifically, the distance between (the center of) the first slider(s) 142 and the second slider(s) 143 is smaller than the trajectory length of the guide track 1451. Preferably, the distance between the first slider(s) 142 and the second slider(s) 143 is greater than the distance between the locking element 1452 and the first end(s) of the guide track 1451, such that when the second slider(s) 143 move(s) along the guide track(s) 1451, the second slider(s) 1 do(es) not engage with the locking element(s) 1452. More preferably, the distance between the first slider(s) 142 and the second slider(s) 143 is generally equal to the distance between the locking element(s) 1452 and the second end(s) of the guide track(s) 1451, such that when the first slider(s) 142 engage(s) with the locking element(s) 1452, the second slider(s) 143 is/are at the position of the second end(s) of the guide track(s) 1451, so that the rotation of the cart 141 can be more stable.

### - Operational Process of the Cover and Opening Mechanism

Referring to Figures 4(a) to 5(c), the components of the opening mechanism 14 are shown when the opening mechanism 14 is in each of a covering state, an open state, or a partially open state.

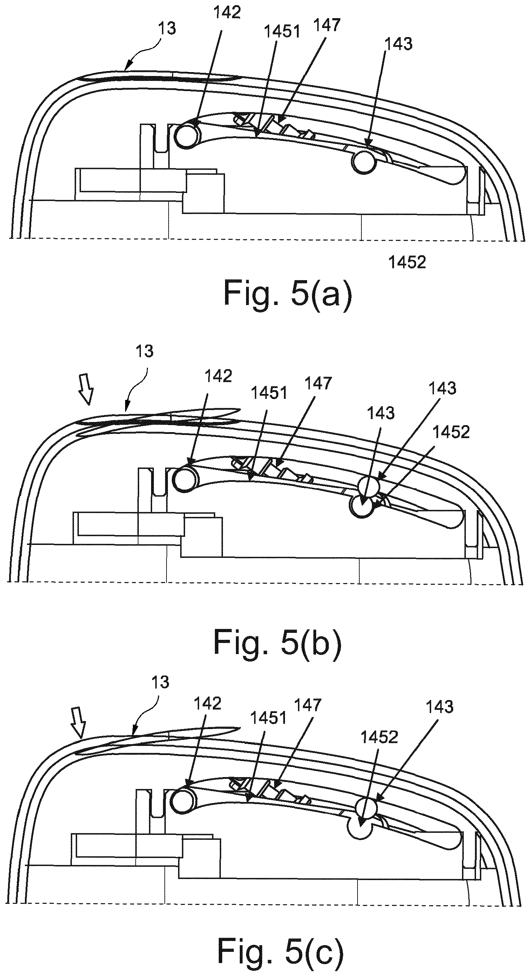

Referring to Figure 4(a), the cover 13 is shown in the closed position and the opening mechanism 14 is in the covering state. In this position, the cover 13 covers the opening of the aerosol generation device 1 and forms a seamless surface with a surrounding surface of the housing 11 (i.e., the closure 111). The horizontal covering surface 1332 of the covering piece 133 protects and separates the opening mechanism 14 from the aerosol generation chamber 12. The vertical sealing surface 1331 is preferably flush with the inner wall of the aerosol generation chamber 12. The opening mechanism 14 is arranged in a way such that when the cover 13 is in the closed position, as shown in Figure 5(a), the locking element 1452 locks and holds (the first slider 142 of) the opening mechanism in place and resists the biasing force of the biasing element 146 (not shown) and the movement of the cover 133 away from the closed position. In this embodiment, the biasing element 146 comprises a helical compression spring (not shown); the traveler-connected end 1462 of the biasing element 146 is compressed by the traveler 1471, which is held in place together with the guide cart 141. The traveler 1471 is at its closest position to the hinged end 1472 of the rigid guiding rod 147. A compressive force from the traveler 147 applies onto the biasing element 146 and acts in line with the axis of the rigid guiding rod 147. A "downward" component of the force of the biasing element 146 holds the first slider 142 within the locking element 1452. The second slider 143 is at the second end of the guide track 1451 and pivotally engages with (the second end of) the guide track 1451.

With the second slider 143 acting as the rotation point, the rigid guiding rod 147 and the cover function as two sides of a lever. Hence, in order to unlock the locking element 1452 so as to transfer the cover 13 from the closed position to the open position, as shown in Figures 4(b), 5(b) and 5(c), the user clicks or pushes the cover 13 vertically, more specifically an end of the cover 13 that is closer to the opening when the cover is at the open position, in a "downward" direction, i.e. a direction that is different from, and more specifically substantially perpendicular to, the sliding directions of the cover 13. Accordingly, the first slider 142 rotates around the second slider 143 and moves upwards, i.e. a direction that is opposite to the moving direction of the cover 13 that is pushed down by the user. In other words, by using the second slider 143 as the rotation or pivot point, the first slider 142 is lifted up by the force of the user on the cover 13 in a downward direction. Then, the biasing element 146, the rigid guiding rod 147 and the traveler 1471 rotate as the first slider 142 of the cart 141 rotates. Preferably, the force provided by a user to the cover 13 in the downward direction is required to continue until the first slider 142 is completely out of the locking element 1452. With the contact between the first slider 142 and the upper longitudinal side of the guide track 1451, the user may sense a resistance and then recognize that the force on the cover can be released. Alternatively, the locking element 1452 is arranged in a shape, e.g., a curved shape at its cover such that by only clicking the cover 13 a little bit, the first slider 142 may smoothly slide out of the locking element 1452. Eventually, when the force from the user is removed, as the opening mechanism 14 is unlocked, the biasing force from the biasing element 146 is released and acts to move or slide the cover 12 to the open position.

In such a way, the opening mechanism is transferred into the partially open state, and the cover 13 is at a transitory or intermediate position, which is between the open position and the closed position. The biasing element 146 exerts a force that acts to move the cover 13 to the open position in the sliding direction, which is substantially horizontal. Both the horizontal and vertical covering surface 1331 1332 protect and separate the opening mechanism 14 from the aerosol generation chamber 12.

Specifically, as the opening mechanism 14 is released from the locking element 1452, the compressive force applied to the biasing element 146 is released. Accordingly, the biasing element 146 exerts a force that acts in line with the axis defined by the rigid guiding rod 147. With the traveler-connected end 1462 of the biasing element 146 moving away from the rod-connected end 1461 of the biasing element 146 along the rigid guiding rod 147, the traveler 1471 is driven accordingly with the biasing force applied thereon, and thus moves along the rigid guiding rod 147 and away from the hinged end 1472 of the rigid guiding rod 147 and towards the other end of the rigid guiding rod 147, which is opposite to the hinged end 1472. This results in that the cart 141 which is engaged with the traveler 1471 moves along the rigid guiding rod 147, and thus the cart 141 drives the cover 13 to the open position along the sliding surface via the connection with the linking part 131 or the covering piece 133.

Referring to Figure 4(c), the cover 13 is then moved to its open position. Preferably, while the first slider 142 reaches the first end of the guide track 1451, the second slider 143 is at the position between the locking element 1452 and the second end of the guide track 1451. In this position, the cover 13 is stopped by a stopper, which is preferably an edge of the opening, the housing 11 or the first end of the guide track 1451. Accordingly, the opening of the aerosol generation chamber 12 is exposed, preferably completely exposed, so that access to the inner space from outside is provided. The vertical covering surface 1333 of the covering piece 133 protects and separates the opening mechanism 14 from the aerosol generation chamber 12, and preferably forms a seamless surface with the surface of the inner wall of the chamber 12 around it.

Conversely, in order to close the opening of the aerosol generation chamber 12, i.e., move the cover 13 from the opening position to the closed position, the user exerts a force on the cover 13 which acts to move the cover 13 towards the closed position, i.e., in a sliding direction that is opposite to the sliding direction driven by the biasing mechanism when opening the cover 13.

Specifically, the user applies a force onto the cover 13 acting to move the cover 13 in a substantially horizontal direction from the open position to the closed position. The user's force is initially resisted by the biasing element 146, so that if the user releases the cover 13 before it reaches the locking position where the first slider(s) 142 engage(s) with the locking element 1452, the cover 13 returns to the open position. As the user applies the force to the cover 13, the cart 141, which is connected to the cover 13, drives the traveler 1471 to move along the rigid guiding rod 147, and the biasing element 146 is thus compressed by the force being applied thereto from the traveler 1471, and the traveler-connected end 1462 of the biasing element 146 moves towards the rod-connected end 1461 along the rigid guiding rod 147. As the user continues to apply the force to the cover 13, the cover is eventually moved to the locking position. Once the first slider 142 of the cart 141 reaches the locking element, the downward component force exerted by the biasing element 146 acts to make the first slider(s) 142 of the cart 141 engage with, i.e., fall into, the locking element(s) 1452. The user, by sensing the uplift movement of the cover 13, recognizes that the cover 13 is locked and can then remove the force from the cover. Eventually, the guide cart 141 is locked in place and the spring 146 is compressed. Preferably, the second slider 143 also reaches the second end of the guide track 1451. With the transition to the locking position, the cover, which acts as another side of the lever of the rigid guiding rod 147, is raised up or moves in an upward direction, which is different from, specifically substantially perpendicular to, the sliding directions of the cover 13, as the first slider 142 moves downward, namely falls within the locking element 1452. Accordingly, the cover 13 forms a seamless surface with a surrounding surface of the housing 11 (i.e., the closure 111) around the cover when the cover completely covers the opening of the aerosol generation chamber 12.

When the cover 13 is in the closed position, the aerosol generation device 1 can be stowed, and the cover 13 prevents the ingress of material or dust into device 1. The locking element 1452 locks the opening mechanism 14 in the covering state, and the cover 13 in the closed position to prevent the cover 13 from moving due to unintentional contact with other objects. When the cover 13 is in the open position, the aerosol generation device 1 can be used, as the biasing element 146 holds the cover 13 in place, and the user can insert or extract the consumable into or from the aerosol generation chamber 12 for consumption.

In a preferred embodiment, a sensor is arranged within locking element 1452, and once it senses that the opening mechanism 14 engages with the locking element 1452, the heating function of the aerosol generation device 1 is stopped.

In another preferred embodiment, an LED light is arranged to indicate the locking state of cover 13.

## Claims

1. An aerosol generation device (1), comprising:
- a housing (11),
- an aerosol generation chamber (12) configured to receive a substrate to generate aerosol and having an opening which is at least partially not covered by the housing (11),
- a cover (13) configured to be in a closed position covering the opening, or in an open position exposing the opening,
- an opening mechanism (14) engaged with the cover (13) and comprising a biasing element (146) biasing the cover (13) toward the open position, and a locking element (1452) configured to releasably lock the cover (13) in the closed position;
the opening mechanism (14) being configured to be in a covering state, an open state, or a partially open state; wherein
when the opening mechanism (14) is in the covering state, the locking element (14) holds the cover (13) in the closed position, and the opening mechanism (14) can be translated into the partially open state,
when the opening mechanism (14) is in the open state, the biasing element (1451) holds the cover (13) in the open position, and the opening mechanism (14) can be translated into the partially open state, and
when the opening mechanism (14) is in the partially open state, the cover (13) is configured to move from the closed position to the open position by a force of the biasing element (1451), or from the open position to the closed position by a force of the user pushing the cover (13) until the cover is locked by the locking element.

2. The aerosol generation device according to the preceding claim, wherein the locking element is further configured to unlock to the cover by an operation of the user when the cover is in the closed position.

3. The aerosol generation device according to any one of the preceding claims, wherein when the opening mechanism transitions from the covering state to the open state, the cover first moves in a first direction by a force of the user so that the cover is unlocked from the closed position, and then moves in a second direction, which is different from the first direction, to the open position; and
when the opening mechanism transitions from the open state to the covering state, the cover moves from the open position to the closed position by a force of the user pushing the cover in a third direction, which is opposite to the second direction, until the cover is locked by the locking element in the closed position.

4. The aerosol generation device according to any one of the preceding claims, wherein the cover comprises a covering surface configured to cover the aerosol generation chamber when the cover is in the closed position, and a sealing surface configured to cover the opening mechanism when the cover is in the open position; preferably, when the cover is in the open position, the sealing surface forms a seamless surface with a surrounding surface of the aerosol generation chamber around the sealing surface so as to cover the opening mechanism.

5. The aerosol generation device according to any one of the preceding claims, wherein the opening mechanism comprises a guide track and a first slider engaged with the cover and configured to slidingly engage with the guide track so that the cover can slide between the open position and the closed position.

6. The aerosol generation device according to the preceding claim, wherein the locking element is a groove arranged on the guide track.

7. The aerosol generation device according to the preceding claim, wherein the guide track has a first end and a second end,
when the cover is in the open position, the first slider is held at the first end by the biasing element; and preferably,
the locking element is arranged on the guide track and in a position between the first end and the second end, so that, when the first slider engages with the locking element, the cover is held in the closed position against the force of the biasing element, and when the cover is moved in the first direction, the first slider is moved in a way such that the first slider can be released from the locking element so as to unlock the cover from the closed position.

8. The aerosol generation device according to the preceding claim, wherein the opening mechanism comprises a second slider engaged with the cover and configured to slidingly engage with the guide track, and when the first slider moves from or engages with the locking element, the second slider is configured to be the rotation point for the first slider.

9. The aerosol generation device according to the preceding claim, wherein the second slider is arranged at an end of the cover that is closest to a center of the opening of the aerosol generation chamber when the cover is in the open position.

10. The aerosol generation device according to any one of claims 8 or 9, wherein the opening mechanism comprises a rigid element, the first slider is provided on the rigid element at a first end of the rigid element and the second slider is provided on a second end of the rigid element, and the rigid element is connected with the cover, preferably with a part of the cover which provides the seamless surface according to claims 4 or 5.

11. The aerosol generation device according to the preceding claim, wherein the first slider and a second slider has a distance therebetween such that when the second slider moves along the guide track, the second slider does not fall into the groove.

12. The aerosol generation device according to any one of claims 8 to 11 and claims 3 or 4, wherein the cover comprises a protrusion comprising the second slider, and the sealing surface is provided on the protrusion.

13. The aerosol generation device according to any one of claims 6 to 12, wherein the housing comprises a sliding surface, the cover is configured to slide along the sliding surface, and the guide track is arranged in such a way that a part of the trace of the first slider is substantially parallel to an outline of the sliding surface.

14. The aerosol generation device according to any one of the preceding claims, wherein the cover forms a seamless surface with a surrounding surface of the housing around the cover when the cover is in the closed position.

15. A method of opening an aerosol generation device according to any one of the preceding claims, comprising the step of pushing the cover of the aerosol generation device down so as to unlock the locking element that locks the cover in the closed position.

## Patentansprüche

1. Aerosolerzeugungsvorrichtung (1), umfassend:
- ein Gehäuse (11),
- eine Aerosolerzeugungskammer (12), die konfiguriert ist, um ein Substrat aufzunehmen, um Aerosol zu erzeugen, und die eine Öffnung aufweist, die zumindest teilweise nicht von dem Gehäuse (11) bedeckt ist,
- eine Abdeckung (13), die konfiguriert ist, um sich in einer geschlossenen Position, die die Öffnung bedeckt, oder in einer offenen Position, die die Öffnung freilegt, zu befinden,
- einen Öffnungsmechanismus (14), der mit der Abdeckung (13) in Eingriff steht und ein Vorspannelement (146) umfasst, das die Abdeckung (13) in Richtung der offenen Position vorspannt, und ein Verriegelungselement (1452), das konfiguriert ist, um die Abdeckung (13) in der geschlossenen Position lösbar zu verriegeln;
wobei der Öffnungsmechanismus (14) konfiguriert ist, um sich in einem Bedeckungszustand, einem offenen Zustand oder einem teilweise offenen Zustand zu befinden; wobei
wenn sich der Öffnungsmechanismus (14) in dem Bedeckungszustand befindet, das Verriegelungselement (14) die Abdeckung (13) in der geschlossenen Position hält und der Öffnungsmechanismus (14) in den teilweise offenen Zustand verschoben werden kann,
wenn sich der Öffnungsmechanismus (14) in dem offenen Zustand befindet, das Vorspannelement (1451) die Abdeckung (13) in der offenen Position hält und der Öffnungsmechanismus (14) in den teilweise offenen Zustand verschoben werden kann, und
wenn sich der Öffnungsmechanismus (14) in dem teilweise offenen Zustand befindet, die Abdeckung (13) konfiguriert ist, um sich durch eine Kraft des Vorspannelements (1451) von der geschlossenen Position in die offene Position oder durch eine Kraft des Benutzers, der die Abdeckung (13) drückt, von der offenen Position in die geschlossene Position zu bewegen, bis die Abdeckung durch das Verriegelungselement verriegelt ist.

2. Aerosolerzeugungsvorrichtung nach dem vorhergehenden Anspruch, wobei das Verriegelungselement ferner konfiguriert ist, um sich durch eine Betätigung des Benutzers von der Abdeckung zu entriegeln, wenn sich die Abdeckung in der geschlossenen Position befindet.

3. Aerosolerzeugungsvorrichtung nach einem der vorhergehenden Ansprüche, wobei, wenn der Öffnungsmechanismus von dem Bedeckungszustand in den offenen Zustand übergeht, sich die Abdeckung zuerst durch eine Kraft des Benutzers in eine erste Richtung bewegt, so dass die Abdeckung von der geschlossenen Position entriegelt wird, und sich dann in eine zweite Richtung, die sich von der ersten Richtung unterscheidet, in die offene Position bewegt; und
wenn der Öffnungsmechanismus von dem offenen Zustand in den Bedeckungszustand übergeht, sich die Abdeckung durch eine Kraft des Benutzers, der die Abdeckung in eine dritte Richtung drückt, die der zweiten Richtung entgegengesetzt ist, von der offenen Position in die geschlossene Position bewegt, bis die Abdeckung durch das Verriegelungselement in der geschlossenen Position verriegelt ist.

4. Aerosolerzeugungsvorrichtung nach einem der vorhergehenden Ansprüche, wobei die Abdeckung eine Bedeckungsfläche, die konfiguriert ist, um die Aerosolerzeugungskammer zu bedecken, wenn sich die Abdeckung in der geschlossenen Position befindet, und eine Dichtungsfläche, die konfiguriert ist, um den Öffnungsmechanismus zu bedecken, wenn sich die Abdeckung in der offenen Position befindet, umfasst; vorzugsweise, wenn sich die Abdeckung in der offenen Position befindet, die Dichtungsfläche eine nahtlose Fläche mit einer umgebenden Fläche der Aerosolerzeugungskammer um die Dichtungsfläche bildet, um den Öffnungsmechanismus zu bedecken.

5. Aerosolerzeugungsvorrichtung nach einem der vorhergehenden Ansprüche, wobei der Öffnungsmechanismus eine Führungsbahn und einen ersten Schieber, der mit der Abdeckung in Eingriff steht und konfiguriert ist, um gleitend mit der Führungsbahn in Eingriff zu stehen, so dass die Abdeckung zwischen der offenen Position und der geschlossenen Position gleiten kann, umfasst.

6. Aerosolerzeugungsvorrichtung nach dem vorhergehenden Anspruch, wobei das Verriegelungselement eine Nut ist, die auf der Führungsbahn angeordnet ist.

7. Aerosolerzeugungsvorrichtung nach dem vorhergehenden Anspruch, wobei die Führungsbahn ein erstes Ende und ein zweites Ende aufweist,
wenn sich die Abdeckung in der offenen Position befindet, der erste Schieber an dem ersten Ende durch das Vorspannelement gehalten wird; und vorzugsweise,
das Verriegelungselement auf der Führungsbahn und in einer Position zwischen dem ersten Ende und dem zweiten Ende angeordnet ist, so dass, wenn der erste Schieber mit dem Verriegelungselement in Eingriff steht, die Abdeckung gegen die Kraft des Vorspannelements in der geschlossenen Position gehalten wird, und wenn die Abdeckung in die erste Richtung bewegt wird, der erste Schieber auf eine solche Weise bewegt wird, dass der erste Schieber von dem Verriegelungselement gelöst werden kann, um die Abdeckung von der geschlossenen Position zu entriegeln.

8. Aerosolerzeugungsvorrichtung nach dem vorhergehenden Anspruch, wobei der Öffnungsmechanismus einen zweiten Schieber umfasst, der mit der Abdeckung in Eingriff steht und konfiguriert ist, um gleitend mit der Führungsbahn in Eingriff zu stehen, und wenn sich der erste Schieber von dem Verriegelungselement bewegt oder mit diesem in Eingriff steht, der zweite Schieber konfiguriert ist, um der Drehpunkt für den ersten Schieber zu sein.

9. Aerosolerzeugungsvorrichtung nach dem vorhergehenden Anspruch, wobei der zweite Schieber an einem Ende der Abdeckung angeordnet ist, das einer Mitte der Öffnung der Aerosolerzeugungskammer am nächsten ist, wenn sich die Abdeckung in der offenen Position befindet.

10. Aerosolerzeugungsvorrichtung nach einem der Ansprüche 8 oder 9, wobei der Öffnungsmechanismus ein starres Element umfasst, der erste Schieber an dem starren Element an einem ersten Ende des starren Elements bereitgestellt ist und der zweite Schieber an einem zweiten Ende des starren Elements bereitgestellt ist und das starre Element mit der Abdeckung, vorzugsweise mit einem Teil der Abdeckung, der die nahtlose Fläche nach Anspruch 4 oder 5 bereitstellt, verbunden ist.

11. Aerosolerzeugungsvorrichtung nach dem vorhergehenden Anspruch, wobei der erste Schieber und ein zweiter Schieber einen Abstand dazwischen aufweisen, so dass, wenn sich der zweite Schieber entlang der Führungsbahn bewegt, der zweite Schieber nicht in die Nut fällt.

12. Aerosolerzeugungsvorrichtung nach einem der Ansprüche 8 bis 11 und Anspruch 3 oder 4, wobei die Abdeckung einen Vorsprung umfasst, der den zweiten Schieber umfasst, und die Dichtungsfläche an dem Vorsprung bereitgestellt ist.

13. Aerosolerzeugungsvorrichtung nach einem der Ansprüche 6 bis 12, wobei das Gehäuse eine Gleitfläche umfasst, die Abdeckung konfiguriert ist, um entlang der Gleitfläche zu gleiten, und die Führungsbahn auf eine solche Weise angeordnet ist, dass ein Teil der Spur des ersten Schiebers im Wesentlichen parallel zu einem Umriss der Gleitfläche ist.

14. Aerosolerzeugungsvorrichtung nach einem der vorhergehenden Ansprüche, wobei die Abdeckung eine nahtlose Fläche mit einer umgebenden Fläche des Gehäuses um die Abdeckung bildet, wenn sich die Abdeckung in der geschlossenen Position befindet.

15. Verfahren zum Öffnen einer Aerosolerzeugungsvorrichtung nach einem der vorhergehenden Ansprüche, umfassend den Schritt des Herunterdrückens der Abdeckung der Aerosolerzeugungsvorrichtung, um das Verriegelungselement, das die Abdeckung in der geschlossenen Position verriegelt, zu entriegeln.

## Revendications

1. Un dispositif de génération d'aérosol (1), comprenant :
- un boîtier (11),
- une chambre de génération d'aérosol (12) configurée pour recevoir un substrat pour générer un aérosol et possédant une ouverture qui est au moins partiellement non-recouverte par le boîtier,
- un couvercle (13) configuré pour être dans une position fermée recouvrant l'ouverture, ou dans une position ouverte exposant l'ouverture,
- un mécanisme d'ouverture (14) en prise avec le couvercle (13) et comprenant un élément de sollicitation (146) sollicitant le couvercle (13) vers la position ouverte, et un élément de verrouillage (1452) configuré pour verrouiller de façon libérable le couvercle (13) dans la position fermée ;
le mécanisme d'ouverture (14) étant configuré pour être dans un état recouvrant, un état ouvert, ou un état partiellement ouvert ; dans lequel
lorsque le mécanisme d'ouverture (14) est dans l'état recouvrant, l'élément de verrouillage (1452) maintient le couvercle (13) dans la position fermée, et le mécanisme d'ouverture (14) peut être translaté jusqu'à l'état partiellement ouvert,
lorsque le mécanisme d'ouverture (14) est dans l'état ouvert, l'élément de sollicitation (1451) maintient le couvercle (13) dans la position ouverte, et le mécanisme d'ouverture (14) peut être translaté jusqu'à l'état partiellement ouvert, et
lorsque le mécanisme d'ouverture (14) est dans l'état partiellement ouvert, le couvercle (13) est configuré pour se déplacer de la position fermée à la position ouverte par une force de l'élément de sollicitation (1451), ou de la position ouverte à la position fermée par une force de l'utilisateur qui appuie sur le couvercle (13) jusqu'à ce que le couvercle soit verrouillé par l'élément de verrouillage.

2. Le dispositif de génération d'aérosol selon la revendication précédente, dans lequel l'élément de verrouillage est en outre configuré pour se déverrouiller du couvercle par un actionnement de l'utilisateur lorsque le couvercle est dans la position fermée.

3. Le dispositif de génération d'aérosol selon l'une des revendications précédentes, dans lequel, lorsque le mécanisme d'ouverture passe de l'état recouvrant à l'état ouvert, le couvercle se déplace tout d'abord dans une première direction par une force de l'utilisateur de sorte que le couvercle soit déverrouillé de la position fermée, et se déplace ensuite dans une seconde direction, qui est différente de la première direction, vers la position ouverte, et
lorsque le mécanisme d'ouverture passe de l'état ouvert à l'état recouvrant, le couvercle se déplace de la position ouverte à la position fermée par une force de l'utilisateur qui appuie sur le couvercle dans une troisième direction, qui est opposée à la seconde direction, jusqu'à ce que le couvercle soit verrouillé par l'élément de verrouillage dans la position fermée.

4. Le dispositif de génération d'aérosol selon l'une des revendications précédentes, dans lequel le couvercle comprend une surface couvrante configurée pour couvrir la chambre de génération d'aérosol lorsque le couvercle est dans la position fermée, et une surface d'étanchéité configurée pour couvrir le mécanisme d'ouverture lorsque le couvercle est dans la position ouverte ; de préférence, lorsque le couvercle est dans la position ouverte, la surface d'étanchéité forme une surface sans solution de continuité avec une surface qui entoure la chambre de génération d'aérosol autour de la surface d'étanchéité de manière à couvrir le mécanisme d'ouverture.

5. Le dispositif de génération d'aérosol selon l'une des revendications précédentes, dans lequel le mécanisme d'ouverture comprend une glissière de guidage et un premier coulisseau compris avec le couvercle et configuré pour venir en prise coulissante avec la glissière de guidage de manière que le couvercle puisse coulisser entre la position ouverte et la position fermée.

6. Le dispositif de génération d'aérosol selon la revendication précédente, dans lequel l'élément de verrouillage est une gorge agencée sur la glissière de guidage.

7. Le dispositif de génération d'aérosol selon la revendication précédente, dans lequel la glissière de guidage possède une première extrémité et une seconde extrémité,
lorsque le couvercle est dans la position ouverte, le premier coulisseau est maintenu au niveau de la première extrémité par l'élément de sollicitation ; et, de préférence,
l'élément de verrouillage est agencé sur la glissière de guidage et dans une position entre la première extrémité et la seconde extrémité de manière que, lorsque le premier coulisseau vient en prise avec l'élément de verrouillage, le couvercle soit maintenu dans la position fermée à l'encontre de la force de l'élément de sollicitation, et, lorsque le couvercle est déplacé dans la première direction, le premier coulisseau est déplacé d'une manière telle que le premier coulisseau puisse être libéré de l'élément de verrouillage de manière à déverrouiller le couvercle depuis la position fermée.

8. Le dispositif de génération d'aérosol selon la revendication précédente, dans lequel le mécanisme d'ouverture comprend un second coulisseau en prise avec le couvercle et configuré pour venir en prise coulissante avec la glissière de guidage, et, lorsque le premier coulisseau se déplace par rapport à, ou vient en prise avec, l'élément de verrouillage, le second coulisseau est configuré pour être le point de rotation pour le premier coulisseau.

9. Le dispositif de génération d'aérosol selon la revendication précédente, dans lequel le second coulisseau est disposé au niveau d'une extrémité du couvercle qui est la plus proche d'un centre de l'ouverture de la chambre de génération d'aérosol lorsque le couvercle est dans la position ouverte.

10. Le dispositif de génération d'aérosol selon l'une des revendications 8 ou 9, dans lequel le mécanisme d'ouverture comprend un élément rigide, le premier coulisseau est disposé sur l'élément rigide au niveau d'une première extrémité de l'élément rigide et le second coulisseau est disposé sur une seconde extrémité de l'élément rigide, l'élément rigide est relié au couvercle, de préférence avec une partie du couvercle qui forme la surface sans solution de continuité selon les revendications 4 ou 5.

11. Le dispositif de génération d'aérosol selon la revendication précédente, dans lequel le premier coulisseau et un second coulisseau présentent entre eux une distance telle que, lorsque le second coulisseau se déplace le long de la glissière de guidage, le second coulisseau ne tombe pas dans la gorge.

12. Le dispositif de génération d'aérosol selon l'une des revendications 8 à 11 et des revendications 3 ou 4, dans lequel le couvercle comprend un relief comprenant le second coulisseau, et la surface d'étanchéité est formée sur le relief.

13. Le dispositif de génération d'aérosol selon l'une des revendications 6 à 12, dans lequel le boîtier comprend une surface de glissement, le couvercle est configuré pour coulisser le long de la surface de glissement, et la glissière de guidage est agencée de manière telle qu'une partie de la trace du premier coulisseau soit substantiellement parallèle à un contour de la surface de glissement.

14. Le dispositif de génération d'aérosol selon l'une des revendications précédentes, dans lequel le couvercle forme une surface sans solution de continuité avec une surface environnante du boîtier autour du couvercle lorsque le couvercle est dans la position fermée.

15. Un procédé d'ouverture d'un dispositif de génération d'aérosol selon l'une des revendications précédentes, comprenant l'étape d'appui vers le bas du couvercle du dispositif de génération d'aérosol de manière à déverrouiller l'élément de verrouillage qui verrouille le couvercle dans la position fermée.
